# EUROPÄISCHE PATENTANMELDUNG

(11) **EP 0 570 864 A2**
(43) Veröffentlichungstag der Anmeldung: **24.11.1993**
(21) Anmeldenummer: 93107899.2
(22) Anmeldetag: 14.05.1993
(51) Int. Cl.: H01L 29/73, H01L 27/082, H01L 29/08

(54) **Monolythisch integrierte pnp-Transistorstruktur**

(30) Priorität: 22.05.1992 DE 4217095
(71) Anmelder: SIEMENS AKTIENGESELLSCHAFT, D-80333 München (DE)
(72) Erfinder: Marcon, Siegfried, Dipl.-Phys., W-8200 Rosenheim (DE); Lenz, Michael, Ing. grad., W-8011 Zorneding (DE); Zierhut, Hermann, W-8000 München 83 (DE)

(57) **Zusammenfassung**

Integrierbare pnp-Transistorstruktur mit in einer epitaktischen Schicht (EPI) über einem Buried-layer (BL) angeordneten, symmetrisch aufgebauten und kammförmig ineinandergreifenden Emitter- und Kollektorbereich (E/K, K/E) bzw. parallel nebeneinander angeordneten Emitter- und Kollektorbereichen (E/K, K/E).

## Beschreibung

Die Erfindung betrifft eine monolytisch integrierte pnp-Transistorstruktur. Bekannte solche Strukturen sind durch eine relativ geringe Stromtragfähigkeit gekennzeichnet. Werden bekannte pnp-Transistorstrukturen im Sättigungsbereich betrieben, so fließt ein relativ großer Substratstrom. Darüberhinaus unterscheiden sich die Vorwärtsstromverstärkung und die Rückwärtsstromverstärkung solcher pnp-Transistoren in hohem Maße.

Werden floatende Schaltelemente benötigt, die in beiden Richtungen Strom führen können, so benötigt man bei Verwendung bekannter pnp-Transistorstrukturen zwei antiparallel geschaltete Transistoren, wobei der Kollektoranschluß des einen Transistors mit dem Emitteranschluß des anderen Transistors zusammengeschaltet ist.

Um den Nachteil der Stromtragfähigkeit in solchen Anordnungen zu beseitigen, sind diese Transistoren mit hochdosiertem Emitter und eventuell - um den Bahnwiderstand anzupassen - mit hochdotiertem Kollektor ausgestattet.

Um die schädlichen Substratströme einzudämmen, ist es bekannt, um solche pnp-Transistorstrukturen herum jeweils einen Ring aus n-dotiertem Material vorzusehen. Zur Regelung des Sättigungsbetriebes sind außerdem p-dotierte Gebiete - sogenannte "Sense-Kollektoren -" bekannt. Sie tragen ebenfalls dazu bei, den Substratstrom zu reduzieren. Diese bekannten Maßnahmen erfordern jeoch jeweils sehr viel Halbleiterfläche und sind somit teuer.

Aufgabe der Erfindung ist es, eine pnp-Transistorstruktur bereitzustellen, die in beiden Richtungen Strom führen kann, wobei mit geringerem Chipflächenbedarf die obengenannten Probleme gelöst werden.

Diese Aufgabe wird durch eine Transistorstruktur gelöst, bei der der Emitterbereich und der Kollektorbereich vollkommen symetrisch aufgebaut sind, wobei die Emitter- und Kollektordiffusionszonen kammförmig ineinandergreifen bzw., bei einer Emitter- und einer Kollektorzone parallel nebeneinanderliegend angeordnet sind. Vorzugsweise sind hierbei die Emitter- und Kollektordiffusionszonen bezüglich ihrer elektrischen Eigenschaften weitgehend identisch aufgebaut. Dadurch wird sowohl in Vorwärtsrichtung als auch in Rückwärtsrichtung eine gleich große Stromverstärkung erreicht. Für die bidirektionale Schaltanwendung ist nur noch eine Transistorstruktur erforderlich, was zu einem erheblich geringerem Halbleiterflächenedarf führt. Die Stromtragfähigkeit einer solchen Anordnung kann durch hochdotierte Emitter- und Kollektorgebiete erreicht werden. Darüberhinaus kann außerdem ein Sense-Kollektor zur Regelung des Sättigungsbereiches vorgesehen sein. Hierbei sind Anordnungen ohne Sense-Kollektor, mit einem Sense-Kollektor oder mit zwei Sense-Kollektoren denkbar.

Günstige Ausgestaltungen sind Gegenstand von Unteransprüchen.

Nachfolgend wird die Erfindung anhand der in den Figuren gezeigten Ausführungsbeispielen näher erläutert. Es zeigt:
- Figur 1: die Draufsicht auf eine Transistorstruktur nach einem besonders günstigen Ausführungsbeispiel der Erfindung,
- Figur 2: eine Schnittdarstellung der Struktur nach Figur 1 entlang der Symmetrielinie X-X betrachtet, den äußeren Teil der Struktur bis zu der Markierungslinie C-D darstellend, und
- Figuren 3 und 4: jeweils eine Schnittdarstellung einer Struktur ähnlich der in Figur 1 dargestellten entlang der Symmetrielinie X-X betrachtet, mit unterschiedlichen Besonderheiten bezüglich der Basisdiffusionszone und der Anordnung von Sense-Kollektoren.

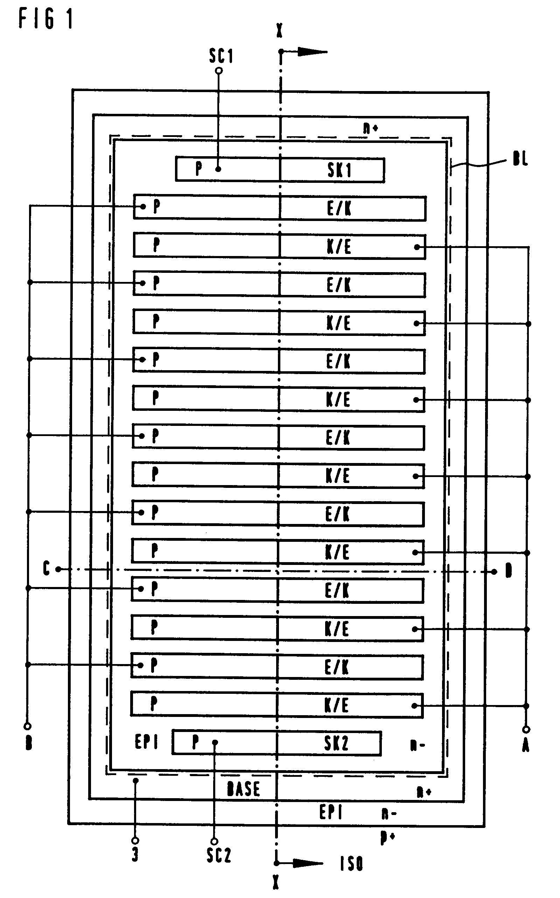

Figur 1 zeigt die Draufsicht auf den Epitaxie- und Diffusionsbereich einer Transistorstruktur nach einem besonders günstigen Ausführungsbeispiel der Erfindung. Hierbei soll innerhalb der dargestellten äußeren Umrandungslinie eine Epitaxiewanne EPI vorgesehen sein, die über einem (nicht dargestellten) Buried-layer BL angeordnet ist. Innerhalb der Epitaxiewanne EPI ist eine ringförmige n⁺-dotierte Basisdiffusionszone BASE angeordnet, die mit einem elektrisch leitendem Basisanschluß 3 verbunden ist. Innerhalb des von der Basisdiffusionszone BASE umschlossenen Bereiches der Epitaxiewanne EPI ist eine gerade Anzahl von länglichen, weitgehend gleichen, nebeneinander angeordneten p-dotierten oder p⁺-dotierten Diffusionszonen E/K, K/E vorgesehen, von denen (in der Darstellung von links nach rechts gezählt) die ungeradzahligen E/K gemeinsam mit einem elektrisch leitenden Emitter/Kollektor-Anschluß B kontaktiert sind und die geradzahligen K/E gemeinsam mit einem elektrisch leitenden Kollektor/Emitter-Anschluß A kontaktiert sind. In Figur 1 sind hierbei sieben Emitter/Kollektor-Diffusionszonen E/K und sieben Kollektor/Emitter-Diffusionszonen K/E dargestellt. Selbstverständlich können jedoch auch, abhängig von der Stromfestigkeit der Struktur weniger oder mehr solcher Kollektor/Emitter- bzw. Emitter/Kollektor-Diffusionszonen nebeneinander angeordnet sein.

Das Ausführungsbeispiel nach Figur 1 sieht außerdem zwischen der äußersten Emitter/Kollektor-Diffusionszone E/K und dem Basisdiffusionsbereich BASE in Längsrichtung neben dieser Emitter/Kollektor-Diffusionszone E/K eine weitere p- bzw. p⁺-dotierte Diffusionszone SK1 vor, die mit einem sogenannten Sense-Kollektoranschluß SC1 kontaktiert ist. Darüberhinaus ist in gleicher Weise zwischen der äußersten Kollektor/Emitter- Diffusionszone K/E und der in diesem Bereich benachbarten Basisdiffusionszone BASE ein weiterer p- bzw. p⁺-dotierter Diffusionsbereich SK2 vorgesehen, der mit einem weiteren Sense-Kollektoranschluß SC2 kontaktiert ist. Diese Sense-Kollektoranschlüsse SC1, SC2 dienen dazu, das Potential in den neben den entsprechenden Sense-Kollektordiffusionszonen SK1, SK2 angeordneten Diffusionszonen E/K bzw. K/E, von außen zu erfassen, so daß die Emitter-Kollektor-Restspannung ermittelt werden kann.

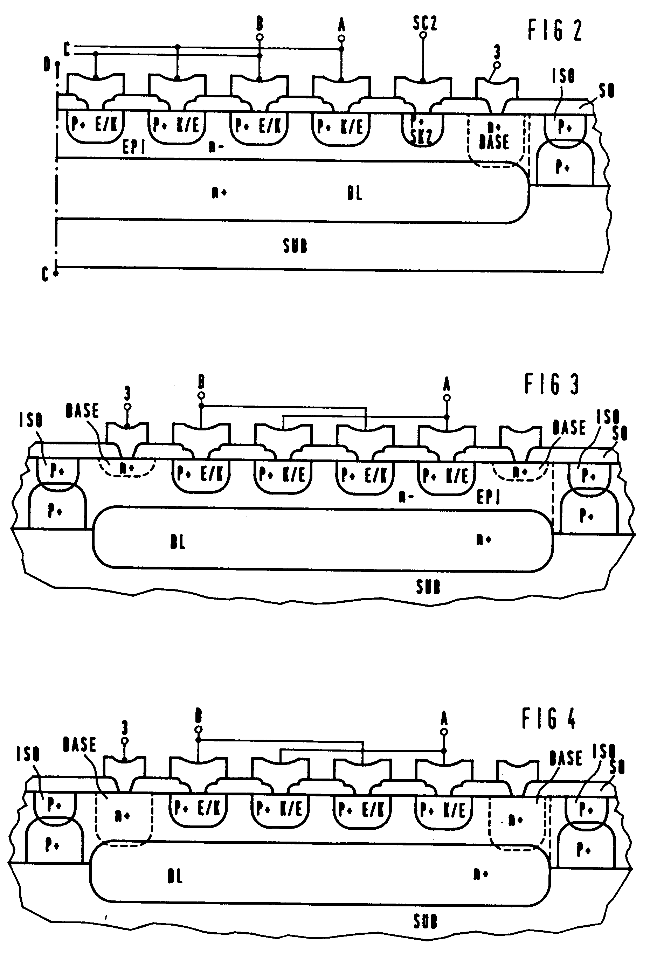

In der Schnittdarstellung von Figur 2 ist ein Sense-Kollektor zu erkennen. Die Ausführungsformen der Figuren 3 und 4 sehen keinen Sense-Kollektor vor.

Figur 2 zeigt eine Schnittdarstellung der Ausführungsform nach Figur 1. Der Schnitt verläuft hierbei entlang der Symmetrielinie X-X. Aufgrund des symmetrischen Aufbaues der Transistorstruktur ist nur der Querschnitt im Randbereich bis zu der Markierungslinie C-D dargestellt. Die Epitaxiewanne EPI ist durch eine p⁺-dotierte Isolation ISO seitlich begrenzt. Unter der Epitaxiwanne EPI ist ein n⁺-dotierter Buried-layer BL vorgesehen. Die Epitaxieschicht EPI ist n⁻ -dotiert. Am äußeren Rand der Epitaxiewanne EPI ist in der Epitaxieschicht ein n⁺⁻dotierter Basisdiffusionsbereich BASE vorgesehen, der mit einem elektrisch leitenden Basisanschluß 3 verbunden ist. In dem in Figur 2 dargestellten Ausführungsbeispiel reicht die Basisdiffusionszone BASE bis in den Bereich des Buried-layers BL. Neben dem Basisdiffusionsbereich BASE ist ein p--dotierter bzw. p⁺-dotierter Diffusionsbereich SK2 vorgesehen, der mit einem Sense-Kollektoranschluß SC2 kontaktiert ist. Neben der Sense-Kollektordiffusionszone SK2 sind im Epitaxiebereich EPI die weitgehend gleichartigen, p--dotierten bzw. p⁺-dotierten, nebeneinander angeordneten Dotierungszonen K/E, E/K angeordnet, die alternierend mit dem Anschluß A bzw. dem Anschluß B kontaktiert sind, so daß jeweils die einander benachbarten Diffusionszonen abwechselnd je nach Betriebsweise der Transistorstruktur zum Emitter/Kollektor oder zum Kollektor/Emitter gehörig kontaktiert sind. Hierzu sind in einer den Halbleiterkörper abdeckenden isolierenden Schicht SO entsprechende Kontaktierungsfenster vorgesehen.

Die Figuren 3 und 4 zeigen jeweils eine Schnittdarstellung einer Struktur ähnlich der in Figur 1 dargestellten, wobei die Schnittlinie entsprechend der in Figur 2 verläuft. Die in den Figuren 3 und 4 dargestellten Ausführungsbeispiele enthalten keine Sense-Kollektoren. Die Emitter- bzw. Kollektorbereiche bestehen aus jeweils zwei Diffusionsbereichen, so daß der Anschluß A mit zwei Diffusionsbereichen K/E kontaktiert ist und der Anschluß B mit zwei Diffusionsbereichen E/K. In dem Ausführungsbeispiel nach Figur 4 ist, wie in dem Ausführungsbeispiel nach Figur 2, der Basisdiffusionsbereich BASE in Form einer Tief-Diffusion ausgeführt und reicht bis in den Buried-layer-Bereich BL hinein. Dadurch unterscheidet sich das Ausführungsbeispiel nach Figur 4 von dem Ausführungsbeispiel nach Figur 2 nur in der Anzahl der EmitterKollektor-Diffusionsbereiche E/K bzw. der Kollektor-EmitterDiffusionsbereiche K/E und dadurch, daß in dem Ausführungsbeispiel nach Figur 4 kein Sense-Kollektor vorgesehen ist. Das Ausführungsbeispiel nach Figur 3 unterscheidet sich von dem Ausführungsbeispiel nach Figur 4 darin, daß der Basisdiffusionsbereich BASE nur in Form einer üblichen, relativ flachen Basisanschlußdiffusion ausgeführt ist und nicht in den Buried-layer-Bereich BL hineinreicht.

Wenn in Figur 1 die Sense-Kollektor-Diffusionsbereiche SK1 und SK2 jeweils innerhalb des ringförmigen Basisdiffusionsbereiches BASE dargestellt sind, so ist die Erfindung nicht auf solche Anordnungen beschränkt. Erfinungsgemäß kann ein Sense-Kollektor-Diffusionsbereich auch außerhalb des ringförmigen Basis-Diffusionsbereiches BASE innerhalb der Epitaxiewanne EPI angeordnet sein. Hierbei ist jedoch sehr zu empfehlen, die Ausgestaltung der Basisdiffusionszone BASE nach Art des in Figur 3 dargestellten Ausführungsbeispiels vorzunehmen, also keine Tiefdiffusion vorzunehmen.

## Patentansprüche

1. Monolytisch integrierbare pnp-Transistorstruktur zum Führen bidirektionaler Ströme mit einem in einem Halbleitersubstrat (SUB) angeordneten Buried-layer-Bereich (BL), mit einem oberhalb des Buried-layer-Bereiches (BL) angeordneten Epitaxiebereich (EPI) und mit in dem Epitaxiebereich (EPI) angeordneten Basis- (BASE), Emitter- (E/K, K/E) und Kollektorbereichen (K/E, E/K), dadurch **gekennzeichnet**, daß mehrere Emitter- (E/K, K/E) und Kollektorbereiche (K/E, E/K) vorgesehen sind, die völlig symmetrisch aufgebaut sind und kammförmig ineinandergreifen.

2. Monolytisch integrierbare pnp-Transistorstruktur zum Führen bidirektionaler Ströme mit einem in einem Halbleitersubstrat (SUB) angeordneten Buried-layer-Bereich (BL), mit einem oberhalb des Buried-layer-Bereiches (BL) angeordneten Epitaxiebereich (EPI) und mit in dem Epitaxiebereich (EPI) angeordneten Basis- (BASE), Emitter- (E/K, K/E) und Kollektorbereichen (K/E, E/K), dadurch **gekennzeichnet**, daß ein Emitter- (E/K, K/E) und ein Kollektorbereich (K/E, E/K) vorgesehen sind, die völlig symmetrisch aufgebaut sind und parallel nebeneinanderliegend angeordnet sind.

3. Transistorstruktur nach Anspruch 1 oder 2, **gekennzeichnet** durch eine hohe Dotierung (p⁺) der Emitter- und Kollektorbereiche (E/K, K/E).

4. Transistorstruktur nach einem der vorhergehenden Ansprüche, dadurch **gekennzeichnet**, daß der Basisdiffusionsbereich (BASE) die Anordnung aus kammförmig ineinandergreifenden Emitter- und Kollektorbereichen (E/K, K/E) umschließt.

5. Transistorstruktur nach Anspruch 4, dadurch **gekennzeichqet**, daß mindestens ein weiterer Kollektordiffusionsbereich (SK1, SK2) zum Fühlen der Restspannung Zwischen den Emitterund Kollektorbereichen (E/K, K/E) angeordnet ist.

6. Transistorstruktur nach Anspruch 5, dadurch **gekennzeichnet**, daß der mindestens eine weitere Kollektordiffusionsbereich (SK1, SK2) zwischen dem Basisdiffusionsbereich (BASE) und der Anordnung aus kammförmig ineinandergreifenden Emitter- und Kollektorbereichen (E/K, K/E) angeordnet ist.

7. Transistorstruktur nach Anspruch 6, dadurch **qekennzeichnet**, daß zwei Kollektorstrukturen (SK1, SK2) zum Fühlen der Restspannung zwischen den Emitter- und Kollektordiffusionsbereichen (E/K, K/E) an gegenüberliegenden Seiten der Anordnung aus kammförmig ineinandergreifenden Emitter- und Kollektordiffusionsbereichen (E/K, K/E) angeordnet sind.
